# EUROPÄISCHE PATENTSCHRIFT

(11) **EP 3 273 479 B1**
(45) Veröffentlichungstag und Bekanntmachung des Hinweises auf die Patenterteilung: **18.07.2018**
(21) Anmeldenummer: 16179938.2
(22) Anmeldetag: 18.07.2016
(51) Int. Cl.: H01L 27/146

(54) **STRAHLUNGSDETEKTOR UND VERFAHREN ZUM MESSEN VON STRAHLUNG MIT EINEM STRAHLUNGSDETEKTOR**
RADIATION DETECTOR AND METHOD FOR MEASURING RADIATION, COMPRISING A RADIATION DETECTOR
DETECTEUR DE RAYONNEMENT ET PROCEDE DE MESURE DE RAYONNEMENT A L'AIDE D'UN DETECTEUR DE RAYONNEMENT

(43) Veröffentlichungstag der Anmeldung: 24.01.2018
(73) Patentinhaber: greateyes GmbH, 12489 Berlin (DE)
(72) Erfinder: Regehly, Martin, 12587 Berlin (DE); Ritter, Sebastian, 10405 Berlin (DE); Stiel, Holger, 13051 Berlin (DE)
(74) Vertreter: Bittner, Thomas L.

(56) Entgegenhaltungen:
- US-A1- 2008 192 435
- US-A1- 2015 054 961

## Beschreibung

Die Erfindung betrifft einen Strahlungsdetektor und ein Verfahren zum Messen von Strahlung mit einem Strahlungsdetektor.

### Hintergrund

Ein Strahlungsdetektor zum Messen von Strahlung ist aus dem Dokument DE 10 2010 061 079 B4 bekannt. Bei dem Strahlungsdetektor ist der zum Messen der detektierenden Strahlung eingesetzte Strahlungssensor in einem evakuierten Detektorgehäuse angeordnet, wobei die zu detektierende Strahlung durch ein in das Detektorgehäuse integriertes Strahlungsfenster einfällt. Im Betrieb wird der Strahlungssensor mit Hilfe der Temperiereinrichtung gekühlt. Hierbei entstehende Wärmeenergie wird über das Detektorgehäuse abgeleitet. Bei dem Strahlungssensor kann es sich um eine gekühlte CCD-Kamera handeln.

Das Dokument US 2015/0054961 A1 offenbart einen Strahlungsdetektor, bei dem ein Strahlungssensor in einem Detektorraum angeordnet ist. Um den Strahlungssensor im Messbetrieb auf tiefe Temperaturen zu kühlen, beispielsweise -60°C oder niedriger, ist eine Temperiereinrichtung vorgesehen, die nach einer Ausführung mit einem Peltier-Element ausgestattet ist.

Das Dokument US 2008/0192435 A1 offenbart einen Strahlungsdetektor, bei dem im Betrieb eines Strahlungssensors entstehende Wärme mittels Wärmestrahlung vom Strahlungssensor abgeführt wird. Der Strahlungssensor ist mittels einer Verlagerungseinrichtung verlagerbar oberhalb eines Fensters für die Wärmeabstrahlung.

### Zusammenfassung

Aufgabe der Erfindung ist es, einen Strahlungsdetektor sowie ein Verfahren zum Messen von Strahlung mit einem Strahlungsdetektor anzugeben, bei denen der Strahlungsdetektor auf verbesserte Art und Weise individuell an unterschiedliche Messsituationen anpassbar ist.

Zur Lösung sind ein Strahlungsdetektor sowie ein Verfahren zum Messen von Strahlung mit einem Strahlungsdetektor nach den unabhängigen Ansprüchen 1 und 10 geschaffen. Alternative Ausgestaltungen sind Gegenstand von abhängigen Unteransprüchen.

Das Detektorgehäuse kann aus mehreren Gehäuseteilen gebildet sein. Beispielsweise sind ein oder mehrere Deckelgehäuseteile sowie ein oder mehrere Bodengehäuseteile vorgesehen. In einer Ausführungsform ist der Strahlungssensor mithilfe der Lagerungseinrichtung am Boden des Detektorgehäuses gelagert. Die Deckelgehäuseteile können einzeln oder als Gruppen von dem oder den Gehäusebodenteilen abnehmbar sein, beispielsweise zu Wartungszwecken.

Das Strahlungsfenster kann im Deckel angeordnet sein.

Die Ableitung der im Betrieb entstehenden Wärme kann über den Boden und / oder den Deckel des Detektorgehäuses erfolgen. Hierzu ist das jeweilige Gehäusebauteil thermisch an die Temperiereinrichtung gekoppelt, also wärmeleitend.

Der Strahlungssensor kann mit einem CCD-Sensor gebildet sein. In der evakuierten Umgebung des Strahlungssensors kann ein Hochvakuum bereitgestellt sein.

In einer Ausführung kann die Lagerungseinrichtung von der Verlagerungseinrichtung gebildet sein.

Die Verlagerungseinrichtung kann eine Translationseinrichtung aufweisen, mit der der Strahlungssensor translatorisch verlagerbar ist, zum Beispiel entlang wenigstens einer Translationsrichtung. In einer Ausführung kann die Verlagerungseinrichtung von der Translationseinrichtung gebildet sein. Die Verlagerungseinrichtung kann ein mithilfe der Translationseinrichtung eingerichtet sein, eine Verlagerung des Strahlungssensors in x-, y- und / oder z-Richtung zu ermöglichen. Ein Verlagern entlang wenigstens zweier zueinander senkrecht stehender Raumrichtungen kann vorgesehen sein. In einer vereinfachten Ausführung kann eine translatorische Verlagerbarkeit entlang nur einer Raumrichtung vorgesehen sein. Alternativ oder ergänzend kann vorgesehen sein, dass die Verlagerungseinrichtung eingerichtet ist, eine Verlagerung des Strahlungssensors um wenigstens eine Drehachse zu ermöglichen, beispielsweise eine auf dem Boden des Detektorgehäuses aufrechtstehende Drehachse. Die Translationseinrichtung kann zum Beispiel ein oder mehrere Piezo-Elemente aufweisen. In einer Ausführung kann die Lagerungseinrichtung von der Translationseinrichtung gebildet sein.

Es kann eine Prüfeinrichtung vorgesehen sein, die eingerichtet ist, eine mittels der Verlagerungseinrichtung für den Strahlungsdetektor bewirkte Verlagerung zu prüfen, beispielsweise mittels einer optischen Messung der Verlagerung, um dann das Ergebnis der optischen, einer elektrischen oder einer anderen Messung, die geeignet ist, die Verlagerung zu erfassen, mit der beabsichtigten Verlagerung zu vergleichen. So kann beispielweise vorgesehen sein, eine anhand des Steuersignals für die Verlagerungseinrichtung angezeigtes Ausmaß der Verlagerung mit der nach dem Verlagern gemessenen Verlagerung zu vergleichen, um so eine exakte Strahlungssensorverlagerung sicherzustellen. Die Prüfeinrichtung kann an der Lagerungseinrichtung angeordnet sein. Auch kann die Prüfeinrichtung an der Gehäusewand angeordnet sein.

Die Temperiereinrichtung kann an der Lagerungseinrichtung angeordnet sein. Die Temperiereinrichtung oder Funktionsteile hiervon können direkt und unmittelbar in die Lagerungseinrichtung integriert sein. Alternativ kann die Temperiereinrichtung lösbar an der Lagerungseinrichtung angeordnet sein, derart, dass die Temperiereinrichtung von der Lagerungseinrichtung abnehmbar ist und hierbei die Lagerung des Strahlungssensors an dem Detektorgehäuse bestehen bleibt. In einer Ausführung kann die Lagerungseinrichtung von der Verlagerungseinrichtung und der Temperiereinrichtung gebildet sein.

Die Temperiereinrichtung kann zum Temperieren des Strahlungssensors über Materialstücke oder Elemente der Verlagerungseinrichtung an den Strahlungssensor thermisch koppeln. Über das Material der Verlagerungseinrichtung kann so das Kühlen des Strahlungssensors ausgeführt werden.

Die Temperiereinrichtung kann zur Wärmeableitung von im Betrieb entstehender Wärme über Materialstücke oder Elemente der Verlagerungseinrichtung an das Detektorgehäuse thermisch koppeln. Auf diese Weise kann die beim Temperieren, insbesondere Kühlen des Strahlungssensors entstehende Wärme über das Material der Verlagerungseinrichtung an das Detektorgehäuse abgeleitet werden.

Die Temperiereinrichtung koppelt zur Wärmeableitung von im Betrieb entstehender Wärme über einen Wärmeenergieleiter an das Detektorgehäuse thermisch, welcher eine Verlagerung der Temperiereinrichtung mittels der Verlagerungseinrichtung zulassend ausgeführt ist. Der Wärmeenergieleiter, welcher getrennt von der Temperiereinrichtung und / oder der Verlagerungseinrichtung gebildet sein kann, kann ein flexibler Wärmeleiter sein, welcher Lage und Form in Abhängigkeit von der Verlagerungsstellung der Temperiereinrichtung selbsttätig anpasst. Der Wärmeenergieleiter kann mit einem oder mehreren Gehäuseteilen des Detektorgehäuses thermisch gekoppelt sein, beispielsweise mit dem Boden und / oder einer Seitenwand des Detektorgehäuses. Der Wärmeenergieleiter kann bei der Verlagerung der Temperiereinrichtung selbsttätig nachführend ausgeführt sein.

Die eine oder die mehreren Leitungen der Anschlusseinrichtung können die Verlagerung des Strahlungssensors mittels der Verlagerungseinrichtung nachstellfrei zulassend ausgeführt sein. Beispielsweise kann es sich um flexible und / oder elastisch streckbare elektrische Anschlussleitungen handeln.

Die Temperiereinrichtung kann zur Kühlenergiezuführung zum Strahlungssensor über einen Kühlenergieleiter an den Strahlungssensor thermisch koppeln, welcher eine Verlagerung des Strahlungssensors mittels der Verlagerungseinrichtung nachstellfrei zulassend ausgeführt ist. Auf diese Weise kann der Kühlenergieleiter, weicher getrennt von der Temperiereinrichtung und / oder der Verlagerungseinrichtung gebildet sein kann, eine Relativbewegung zwischen Strahlungssensor und Temperiereinrichtung selbsttätig nachführend vornehmen.

Am Detektorgehäuse kann ein gedichteter Fluidstutzen angeordnet sein, über welchen das Detektorgehäuse evakuiert und / oder mit einem Fluid befüllt werden kann. Der Fluidstutzen kann mittels einer reversiblen oder einer nicht reversiblen Dichtung in das Detektorgehäuse eingebettet sein. Der Fluidstutzen kann am Boden oder im Bereich eines Deckelbauteils des Detektorgehäuses angeordnet sein. Als Fluid kann zum Beispiel Helium- oder Stickstoffgas eingebracht werden.

Das Strahlungsfenster kann als geschlossenes Fenster ausgeführt sein, wodurch die evakuierte Umgebung vollständig im Detektorgehäuse gebildet ist. Bei dieser Ausführungsform ist das Detektorgehäuse als geschlossenes Gehäuse ausgeführt. Alternativ kann vorgesehen sein, dass das Strahlungsfenster offen ist und dass das Detektorgehäuse über das offene Strahlungsfenster an ein evakuiertes Kammergehäuse koppelt, wobei die zu detektierende Strahlung aus dem evakuierten Kammergehäuse über das offene Strahlungsfenster zum Strahlungssensor hin gelangt. Die evakuierte Umgebung ist bei einer solchen Anordnung über den Detektorraum hinaus in die evakuierte Kammer erweitert. Zumindest im Fall des offenen Strahlungsfensters kann eine Ausführung ohne gedichteten Fluidstutzen am Detektorgehäuse vorgesehen sein.

Die vorangehend im Zusammenhang mit dem Strahlungsdetektor erläuterten alternativen Ausgestaltungen können in Verbindung mit dem Verfahren zum Messen von Strahlung mit dem Strahlungsdetektor entsprechend vorgesehen sein.

### Beschreibung von Ausführungsbeispielen

Im Folgenden werden weitere Ausführungsbeispiele unter Bezugnahme auf Figuren einer Zeichnung näher erläutert. Hierbei zeigen:
- Fig. 1: eine schematische Querschnittsdarstellung eines Strahlungsdetektors mit einem geschlossenen Strahlungsfenster;

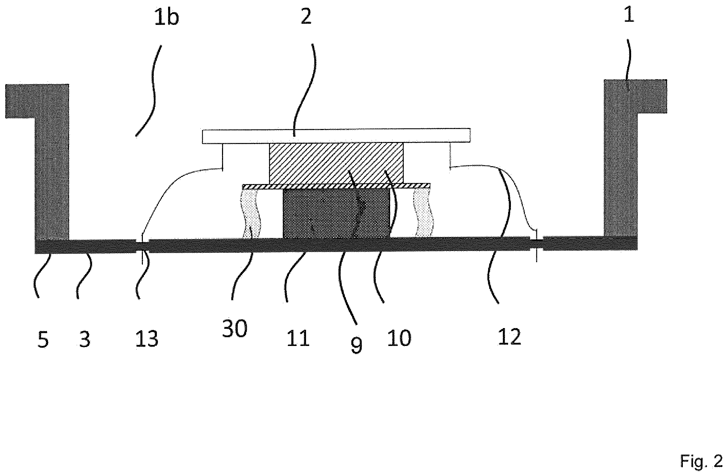

- Fig. 2: eine schematische Querschnittsdarstellung eines Strahlungsdetektors mit einem offenen Strahlungsfenster;
- Fig. 3: eine schematische Darstellung einer Anordnung mit einem Strahlungssensor, der auf einer Verlagerungseinrichtung und einer Temperiereinrichtung lagert; und
- Fig. 4: eine schematische Darstellung einer Anordnung mit einem Strahlungssensor, der auf einer Temperiereinrichtung und einer Verlagerungseinrichtung lagert.

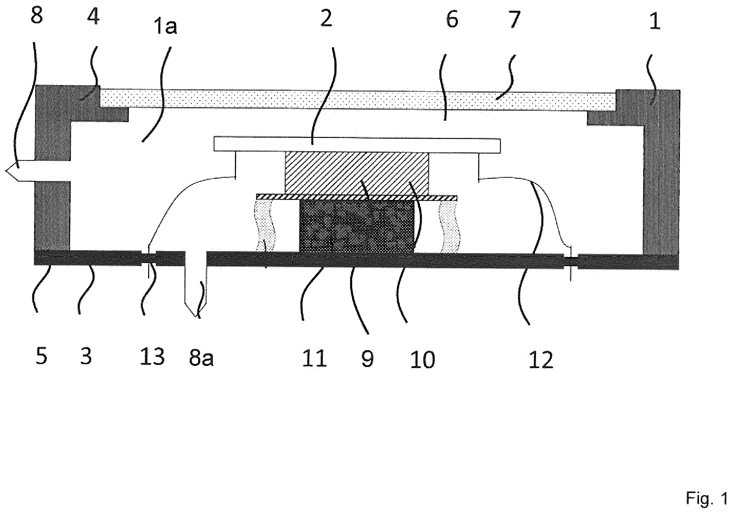

Fig. 1 zeigt eine schematische Darstellung eines Strahlungsdetektors, bei dem in einem Detektorgehäuse 1 ein Strahlungssensor 2, beispielsweise ein CCD-Sensor, in einer evakuierten Umgebung 1a angeordnet ist. Bei der gezeigten Ausführungsform weist das Detektorgehäuse 1 als Gehäusebauteile ein Bodenteil 3 sowie ein Kopfteil 4 auf. Das Bodenteil 3 und das Kopfteil 4 sind über eine Dichtung 5 verbunden.

In das Detektorgehäuse 1 ist ein Strahlungsfenster 6 integriert, dass bei der gezeigten Ausführungsform in Fig. 1 mit einem Fensterteil 7 verschlossen ist. In dem Detektorgehäuse 1 ist ein gegen die Umgebung fluiddicht abgeschlossener Raum 1a geschaffen, der über einen Fluidstutzen 8 im Kopfteil 4 evakuierbar ist, beispielweise zum Ausbilden eines Hochvakuums. Alternativ oder ergänzend kann über den Fluidstutzen 8 ein Fluid in dem abgeschlossenen Raum 1a eingebracht werden.

Bei der in Fig. 1 gezeigten Ausführung ist eine weiterer Fluidstutzen 8a im Bodenteil 3 vorgesehen, welcher dem gleichen Zweck wie der Fluidstutzen 8 dient. Es kann auch nur einer der Fluidstutzen 8, 8a vorgesehen sein.

Der Strahlungssensor 2 ist mithilfe einer Lagerungseinrichtung 9 an dem Bodenteil 3 gelagert. Bei der dargestellten Ausführungsform ist die Lagerungseinrichtung 9 von einer Temperiereinrichtung 10, beispielsweise ein Peltier-Element, sowie einer Verlagerungseinrichtung 11 gebildet, die zum Beispiel eine Translationseinrichtung aufweist. Mithilfe der Verlagerungseinrichtung 11 kann der Strahlungssensor 2 innerhalb des Detektorgehäuses 1 in verschiedene Messstellungen verlagert werden, sodass jeweils durch das Strahlungsfenster 6 einfallende Strahlung mit Hilfe des Strahlungssensors 2 detektiert werden kann.

Anschlüsse 12, die insbesondere dazu dienen, den Strahlungssensor 2 mit elektrischer Energie zu versorgen, sind über fluiddichte Gehäusedurchführungen 13 aus dem Detektorgehäuse 1 herausgeführt.

Es können weitere fluiddichte Gehäusedurchführungen für Leitungen und / oder Schläuche vorgesehen sein, zum Beispiel im Bodenteil 3, welche im Detektorgehäuse 1 zum Beispiel an die Temperiereinrichtung 10 koppeln.

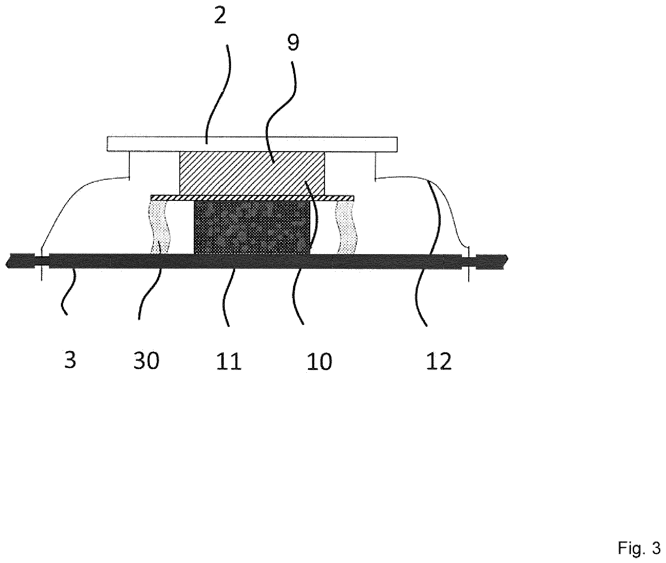

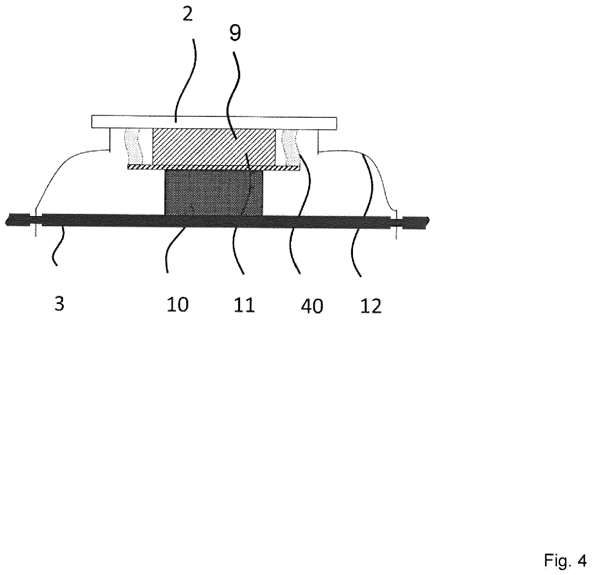

Die Fig. 3 und 4 zeigen schematische Darstellungen, bei denen die Lagerungseinrichtung 9 von einer gestapelten Anordnung der Temperiereinrichtung 10 und der Verlagerungseinrichtung 11 gebildet ist. Bei der Ausgestaltung in Fig. 3 ist die Verlagerungseinrichtung 11 auf dem Bodenteil 3 angeordnet. Auf der Verlagerungseinrichtung 11 lagert die Temperiereinrichtung 10. Bei der Ausführungsform in Fig. 4 ist diese Anordnung umgekehrt.

Bei dem Ausführungsbeispiel in Fig. 3 sind thermische Wärmebrücken 30 vorgesehen zwischen der Temperiereinrichtung 10 und dem Bodenteil 3. Bei der Ausgestaltung in Fig. 4 sind thermische Kältebrücken 40 zwischen dem Strahlungssensor 2 und der untenliegenden Temperiereinrichtung 10 angeordnet. Die thermische Wärmebrücke 30 und die thermischen Kältebrücken 40 sind getrennt von der Temperiereinrichtung 10 und der Verlagerungseinrichtung 11 gebildet.

Die in der vorstehenden Beschreibung, den Ansprüchen sowie der Zeichnung offenbarten Merkmale können sowohl einzeln als auch in beliebiger Kombination für die Verwirklichung der verschiedenen Ausführungsformen von Bedeutung sein.

## Patentansprüche

1. Strahlungsdetektor, mit:
- einem Detektorgehäuse (1), in dem ein Detektorraum (1a) gebildet ist;
- einem Strahlungsfenster (6), welches in das Detektorgehäuse (1) integriert und für zu detektierende Strahlung durchlässig ist, derart, dass die zu detektierende Strahlung durch das Strahlungsfenster (6) in den Detektorraum (1a) einfallen kann;
- einem Strahlungssensor (2), der in einer evakuierten Umgebung des Detektorraums (1a) aufgenommen ist, derart, dass die durch das Strahlungsfenster (6) einfallende Strahlung mit dem Strahlungssensor (2) detektierbar ist;
- einer Lagerungseinrichtung (9), mit der der Strahlungssensor (2) an dem Detektorgehäuse (1) gelagert ist;
- einer Temperiereinrichtung (10), die in dem Detektorraum (1a) ist und an den Strahlungssensor (2) thermisch koppelt, um diesen zu temperieren, wobei eine Ableitung von Wärme, die beim Betrieb der Temperiereinrichtung (10) entsteht, über das Detektorgehäuse (1) erfolgt, wobei die Temperiereinrichtung (10) zur Wärmeableitung von im Betrieb entstehender Wärme über einen Wärmeenergieleiter (30) an das Detektorgehäuse (1) thermisch koppelt, welcher eine Verlagerung der Temperiereinrichtung (10) mittels einer Verlagerungseinrichtung (11) zulassend ausgeführt ist;
- einer Anschlusseinrichtung (12), bei der eine oder mehrere Leitungen aus dem Detektorraum (1a) durch das Detektorgehäuse (1) fluiddicht abgedichtet nach außen geführt sind; und
- der Verlagerungseinrichtung (11), die an der Lagerungseinrichtung (9) angeordnet und eingerichtet ist, um den Strahlungssensor (2) in dem Detektorraum (1a) in unterschiedliche Messstellungen zu verlagern, in denen jeweils einfallende Strahlung mit dem Strahlungssensor (2) detektierbar ist.

2. Strahlungsdetektor nach Anspruch 1, **dadurch gekennzeichnet, dass** die Verlagerungseinrichtung (11) eine Translationseinrichtung aufweist, mit der der Strahlungssensor (2) translatorisch verlagerbar ist.

3. Strahlungsdetektor nach Anspruch 1 oder 2, **dadurch gekennzeichnet, dass** die Temperiereinrichtung (10) an der Lagerungseinrichtung (9) angeordnet ist.

4. Strahlungsdetektor nach mindestens einem der Ansprüche 1 bis 3, **dadurch gekennzeichnet, dass** die Temperiereinrichtung (10) zum Temperieren des Strahlungssensors (2) über Materialstücke der Verlagerungseinrichtung (11) an den Strahlungssensor (2) thermisch koppelt.

5. Strahlungsdetektor nach mindestens einem der Ansprüche 1 bis 3, **dadurch gekennzeichnet, dass** die Temperiereinrichtung (10) zur Wärmeableitung von im Betrieb entstehender Wärme über Materialstücke der Verlagerungseinrichtung (11) an das Detektorgehäuse (1) thermisch koppelt.

6. Strahlungsdetektor nach mindestens einem der vorangehenden Ansprüche, **dadurch gekennzeichnet, dass** die eine oder die mehreren Leitungen der Anschlusseinrichtung (12) die Verlagerung des Strahlungssensors (2) mittels der Verlagerungseinrichtung (11) nachstellfrei zulassend ausgeführt sind.

7. Strahlungsdetektor nach mindestens einem der vorangehenden Ansprüche, **dadurch gekennzeichnet, dass** die Temperiereinrichtung (10) zur Kühlenergiezuführung zum Strahlungssensor (2) über einen Kühlenergieleiter (40) an den Strahlungssensor (2) thermisch koppelt, welcher eine Verlagerung des Strahlungssensors mittels der Verlagerungseinrichtung (11) nachstellfrei zulassend ausgeführt ist.

8. Strahlungsdetektor nach mindestens einem der vorangehenden Ansprüche, **dadurch gekennzeichnet, dass** am Detektorgehäuse (1) ein gedichteter Fluidstutzen (8) angeordnet ist, über welchen das Detektorgehäuse (1) evakuiert und / oder mit einem Fluid befüllt werden kann.

9. Strahlungsdetektor nach mindestens einem der vorangehenden Ansprüche, dadurch g e - **kennzeichnet,** dass das Strahlungsfenster (6) als geschlossenes Fenster ausgeführt ist, wodurch die evakuierte Umgebung vollständig im Detektorgehäuse (1) gebildet ist.

10. Verfahren zum Messen von Strahlung mit einem Strahlungsdetektor, wobei bei dem Verfahren
- Bereitstellen eines Strahlungsdetektors, mit
- einem Detektorgehäuse (1), in dem ein Detektorraum (1a) gebildet ist;
- einem Strahlungsfenster (6), welches in das Detektorgehäuse (1) integriert und für zu detektierende Strahlung durchlässig ist, derart, dass die zu detektierende Strahlung durch das Strahlungsfenster (6) in den Detektorraum (1a) einfallen kann;
- einem Strahlungssensor (2), der in einer evakuierten Umgebung des Detektorraums (1a) aufgenommen ist; und
- einer Lagerungseinrichtung (9), mit der der Strahlungssensor (2) an dem Detektorgehäuse (1) gelagert ist;
- Temperieren des Strahlungssensors (2) mittels einer Temperiereinrichtung (10), die in dem Detektorraum (1a) angeordnet ist und an den Strahlungssensor (2) thermisch koppelt,
wobei die Temperiereinrichtung (10) über einen Wärmeenergieleiter (30) an das Detektorgehäuse (1) thermisch koppelt und hierüber im Betrieb entstehende Wärme abführt und wobei der Wärmeenergieleiter (30) eine Verlagerung der Temperiereinrichtung (10) mittels der Verlagerungseinrichtung (11) zulassend ausgeführt ist;
- Ableiten von Wärme, die beim Temperieren des Strahlungssensors (2) entsteht, über das Detektorgehäuse (1);
- Messen der zu detektierenden Strahlung mittels des temperierten Strahlungssensors (2), wenn dieser in einer ersten Messstellung innerhalb des Detektorraums (1a) angeordnet ist; und
- Verlagern des Strahlungssensors (2) in eine zweite Messstellung, die von der ersten Messstellung verschieden ist, mittels einer an der Lagerungseinrichtung (9) angeordneten Verlagerungseinrichtung (11) und Messen der zu detektierenden Strahlung mittels des temperierten Strahlungssensors (2), wenn dieser in der zweiten Messstellung innerhalb des Detektorraums (1a) angeordnet ist.

## Claims

1. A radiation detector with:
- a detector housing (1) in which a detector chamber (1a) is formed;
- a radiation window (6), which is integrated into the detector housing (1) and is permeable for radiation to be detected, in such a way that the radiation to be detected can pass through the radiation window (6) into the detector chamber (1a);
- a radiation sensor (2), which is accommodated in an evacuated environment of the detector chamber (1a), in such a way that the radiation passing through the radiation window (6) can be detected by the radiation sensor (2);
- a mounting device (9), with which the radiation sensor (2) is mounted on the detector housing (1);
- a temperature-regulating device (10), which is in the detector chamber (1a) and is thermally coupled with the radiation sensor (2) in order to temperature-regulate the latter, wherein a dissipation of heat, which arises during the operation of the temperature-regulating device (10), takes place via the detector housing (1), wherein, for the heat dissipation of heat arising during operation, the temperature-regulating device (10) is thermally coupled with the detector housing (1) via a thermal energy conductor (30), which is configured to permit a displacement of the temperature-regulating device (10) by means of the displacement device (11);
- a connection device (12), in which one or more lines are led out of the detector chamber (1a), in a fluid-tight sealed manner, through the detector housing (1) to the exterior; and
- the displacement device (11), which is disposed on the mounting device (9) and is configured to displace the radiation sensor (2) in the detector chamber (1a) into different measurement positions in which, respectively, radiation incident at the time can be detected with the radiation sensor (2).

2. The radiation detector according to claim 1, **characterized in that** the displacement device (11) comprises a translation device with which the radiation sensor (2) can be displaced in a translatory manner.

3. The radiation detector according to claim 1 or 2, **characterized in that** the temperature-regulating device (10) is disposed on the mounting device (9).

4. The radiation detector according to at least one of the claims 1 to 3, **characterized in that**, for the temperature regulation of the radiation sensor (2), the temperature-regulating device (10) is thermally coupled with the radiation sensor (2) via material pieces of the displacement device (11).

5. The radiation detector according to at least one of the preceding claims, **characterized in that**, for the heat dissipation of heat arising during operation, the temperature-regulating device (10) is thermally coupled with the detector housing (1) via material pieces of the displacement device (11).

6. The radiation detector according to at least one of the preceding claims, **characterized in that** the one or the plurality of lines of the connection device (12) are configured to permit the displacement of the radiation sensor (2) by means of the displacement device (11) in a manner that does not require readjustment.

7. The radiation detector according to at least one of the preceding claims, **characterized in that**, for the cooling energy supply to the radiation sensor (2), the temperature-regulating device (10) is thermally coupled with the radiation sensor (2) via a cooling energy conductor (40), which is configured to permit a displacement of the radiation sensor by means of the displacement device (11) in a manner that does not require readjustment.

8. The radiation detector according to at least one of the preceding claims, **characterized in that** a sealed fluid connecting piece (8) is disposed on the detector housing (1), via which connecting piece the detector housing (1) can be evacuated and/or filled with a fluid.

9. The radiation detector according to at least one of the preceding claims, **characterized in that** the radiation window (6) is constituted as a closed window, whereby the evacuated environment is formed entirely in the detector housing (1).

10. A method for measuring radiation with a radiation detector, wherein the method comprises
- providing a radiation detector, with
- a detector housing (1) in which a detector chamber (1a) is formed;
- a radiation window (6), which is integrated into the detector housing (1) and is permeable for radiation to be detected, in such a way that the radiation to be detected can pass through the radiation window (6) into the detector chamber (1a);
- a radiation sensor (2), which is accommodated in an evacuated environment of the detector chamber (1a), and
- a mounting device (9), with which the radiation sensor (2) is mounted on the detector housing (1);
- temperature-regulating the radiation sensor (2) by means of a temperature-regulating device (10), which is disposed in the detector chamber (1a) and thermally couples with the radiation sensor (2), wherein the temperature-regulating device (10) thermally couples with the detector housing (1) via a thermal energy conductor (30) and dissipates heat arising during operation via the thermal energy conductor (30), and wherein the thermal energy conductor (30) is configured to permit a displacement of the temperature-regulating device (10) by means of the displacement device (11);
- dissipating heat arising during the temperature regulation of the radiation sensor (2) via the detector housing (1);
- measuring the radiation to be detected by means of the temperature-regulated radiation sensor (2) when the latter is disposed in a first measurement position inside the detector chamber (1a); and
- displacing the radiation sensor (2) into a second measurement position, which is different from the first measurement position, by means of a displacement device (11) disposed on the mounting device (9) and measuring the radiation to be detected by means of the temperature-regulated radiation sensor (2) when the latter is disposed in the second measurement position inside the detector chamber (1a).

## Revendications

1. Détecteur de rayonnement comprenant :
- un boîtier de détecteur (1) dans lequel est formé un espace de détecteur (1a) ;
- une fenêtre de rayonnement (6) intégrée dans le boîtier de détecteur (1) et transparente au rayonnement à détecter, de telle façon que le rayonnement à détecter peut entrer dans l'espace de détecteur (1a) à travers la fenêtre de rayonnement (6) ;
- un capteur de rayonnement (2) reçu dans l'environnement évacué de l'espace de détecteur (1a), de telle façon que le rayonnement entrant à travers la fenêtre de rayonnement (6) peut être détecté à l'aide du capteur de rayonnement (2) ;
- un dispositif de support (9) permettant de monter le capteur de rayonnement (2) sur le boîtier de détecteur (1) ;
- un dispositif de régulation de température (10) situé dans l'espace de détecteur (1a) et couplé thermiquement au capteur de rayonnement (2) pour réguler la température de celui-ci, la chaleur générée pendant le fonctionnement du dispositif de régulation de température (10) étant évacuée par le biais du boîtier de détecteur (1), le dispositif de régulation de température (10) étant couplé thermiquement au boîtier de détecteur (1) pour évacuer la chaleur générée pendant le fonctionnement par le biais d'un conducteur d'énergie thermique (30) conçu de manière à autoriser un déplacement du dispositif de régulation de température (10) à l'aide d'un dispositif de déplacement (11) ;
- un dispositif de raccordement (12) dans lequel un ou plusieurs câbles sont guidés vers l'extérieur hors de l'espace de détecteur (1a) à travers le boîtier de détecteur (1) de manière étanche au fluide ; et
- le dispositif de déplacement (11) disposé sur le dispositif de support (9) et conçu pour déplacer le capteur de rayonnement (2) dans l'espace de détecteur (1a) vers différentes positions de mesure, dans lesquelles un rayonnement entrant respectif peut être détecté avec le capteur de rayonnement (2).

2. Détecteur de rayonnement selon la revendication 1, **caractérisé en ce que** le dispositif de déplacement (11) comporte un moyen de translation permettant de déplacer le capteur de rayonnement (2) en translation.

3. Détecteur de rayonnement selon la revendication 1 ou 2, **caractérisé en ce que** le dispositif de régulation de température (10) est disposé sur le dispositif de support (9).

4. Détecteur de rayonnement selon l'une au moins des revendications 1 à 3, **caractérisé en ce que** le dispositif de régulation de température (10) est couplé thermiquement au capteur de rayonnement (2) pour réguler la température du capteur de rayonnement (2) par des pièces de matériau du dispositif de déplacement (11).

5. Détecteur de rayonnement selon l'une au moins des revendications 1 à 3, **caractérisé en ce que** le dispositif de régulation de température (10) est couplé thermiquement au boîtier de détecteur (1) par des pièces de matériau du dispositif de déplacement (11) pour évacuer la chaleur générée pendant le fonctionnement.

6. Détecteur de rayonnement selon l'une au moins des revendications précédentes, **caractérisé en ce que** les un ou plusieurs câbles du dispositif de raccordement (12) sont conçus de manière à permettre le déplacement du capteur de rayonnement (2) en ajustement libre à l'aide du dispositif de déplacement (11).

7. Détecteur de rayonnement selon l'une au moins des revendications précédentes, **caractérisé en ce que** le dispositif de régulation de température (10) est couplé thermiquement au capteur de rayonnement (2) par le biais d'un conducteur d'énergie de refroidissement (40) pour alimenter le capteur de rayonnement (2) en énergie de refroidissement, lequel est conçu de manière à permettre un déplacement du capteur de rayonnement en ajustement libre au moyen du dispositif de déplacement (11).

8. Détecteur de rayonnement selon l'une au moins des revendications précédentes, **caractérisé en ce qu'**un raccord de fluide étanchéifié (8) est disposé sur le boîtier de détecteur (1), par lequel le boîtier de détecteur (1) peut être évacué et/ou rempli avec un fluide.

9. Détecteur de rayonnement selon l'une au moins des revendications précédentes, **caractérisé en ce que** la fenêtre de rayonnement (6) est conçue comme une fenêtre fermée, moyennant quoi l'environnement évacué est formé entièrement dans le boîtier de détecteur (1).

10. Procédé pour la mesure d'un rayonnement à l'aide d'un détecteur de rayonnement, comprenant :
- la mise à disposition d'un détecteur de rayonnement avec
- un boîtier de détecteur (1) dans lequel est formé un espace de détecteur (1a) ;
- une fenêtre de rayonnement (6) intégrée dans le boîtier de détecteur (1) et transparente au rayonnement à détecter, de telle façon que le rayonnement à détecter peut entrer dans l'espace de détecteur (1a) à travers la fenêtre de rayonnement (6) ;
- un capteur de rayonnement (2) reçu dans un environnement évacué de l'espace de détecteur (1a) ; et
- un dispositif de support (9) permettant de supporter le capteur de rayonnement (2) sur le boîtier de détecteur (1) ;
- la régulation de température du capteur de rayonnement (2) à l'aide d'un dispositif de régulation de température (10) disposé dans l'espace de détecteur (1a) et couplé thermiquement au capteur de rayonnement (2),
dans lequel le dispositif de régulation de température (10) est couplé thermiquement au boîtier de détecteur (1) par le biais d'un conducteur d'énergie thermique (30) et évacue ainsi de la chaleur générée pendant le fonctionnement, et dans lequel le conducteur d'énergie thermique (30) est conçu de manière à permettre un déplacement du dispositif de régulation de température (10) à l'aide d'un dispositif de déplacement (11) ;
- l'évacuation de la chaleur générée pendant la régulation de température du capteur de rayonnement (2), par le biais du boîtier de détecteur (1) ;
- la mesure du rayonnement à détecter à l'aide du capteur de rayonnement (2) régulé en température, lorsque celui-ci est disposé à l'intérieur de l'espace de détecteur (1a) dans une première position de mesure ; et
- le déplacement du capteur de rayonnement (2) vers une deuxième position de mesure différente de la première position de mesure, à l'aide d'un dispositif de déplacement (11) disposé sur le dispositif de support (9), et la mesure du rayonnement à détecter à l'aide du capteur de rayonnement (2) régulé en température, lorsque celui-ci est placé à l'intérieur de l'espace de détecteur (1a) dans la deuxième position de mesure.
